# EUROPÄISCHE PATENTSCHRIFT

(11) **EP 0 464 456 B1**
(45) Veröffentlichungstag und Bekanntmachung des Hinweises auf die Patenterteilung: **12.03.1997**
(21) Anmeldenummer: 91109974.5
(22) Anmeldetag: 18.06.1991
(51) Int. Cl.: H04B 10/14, H01S 3/096

(54) **Laserdiodensender**
Laser diode emitter
Emetteur à diode laser

(30) Priorität: 03.07.1990 DE 4021129
(43) Veröffentlichungstag der Anmeldung: 08.01.1992
(73) Patentinhaber: SIEMENS AKTIENGESELLSCHAFT, 80333 München (DE)
(72) Erfinder: Wünsche, Ullrich, Dipl.-Ing., W-8034 Germering (DE)

(56) Entgegenhaltungen:
- GB-A- 2 234 408
- IEEE-MTT-S INTERNATIONAL MICROWAVE SYMPOSIUM DIGEST Nr. T-16, 4. Juni 1986, BALTIMORE, USA Seiten 523 - 526 CARVALHO AND SALLES 'Flat microwave response of directly modulated laser diodes'
- PATENT ABSTRACTS OF JAPAN vol. 12, no. 196 (E-618)(3043) 7. Juni 1988 & JP-A-62 298 243

## Beschreibung

Die Erfindung betrifft einen Laserdiodensender entsprechend dem Oberbegriff des Anspruchs 1.

Ein Laserdiodensender der vorgenannten Art ist aus IEEE-MTT-S INTERNATIONAL MICROWAVE SYMPOSIUM DIGEST Nr. T-16, 4. Juni 1986, BALTIMORE, USA, Seiten 523 - 526 bekannt. Auch bei dem dort beschriebenen Laserdiodensender erfolgt die Anpassung durch ein an die Verbindungsleitung zwischen Lasertreiber und Lasermodul angeschlossenes Leitungsnetzwerk.

Ein Laserdiodensender für Bitraten von wenigstens einigen hundert MBit/s ist aus der EP-Al 0 242 591, insbesondere deren Fig. 3 und zugehöriger Beschreibung bekannt. Ein weiterer Laserdiodensender mit einem handelsüblichen Lasermodul ist in der deutschen Patentanmeldung P 39 22 800.2 beschrieben. Derartige Laserdiodensender enthalten zur Erzeugung des Modulationsstroms für die Laserdiode eine gesteuerte Stromquelle, die üblicherweise in Differenzverstärkertechnik realisiert wird. Bei höheren Bitraten wird der Lasertreiber dabei mit einem Abschlußwiderstand an den Wellenwiderstand der Zuleitung zum Lasermodul angepaßt, ebenso ist das Lasermodul hinsichtlich seines Eingangswiderstandes an den Wellenwiderstand der Zuleitung angepaßt. Durch die Anpassung mit dem Abschlußwiderstand werden Reflektionen am und im Lasermodul, die auf der Zuleitung zum Lasertreiber zurücklaufen, weitgehend im Abschlußwiderstand absorbiert. Da der Abschlußwiderstand etwa den gleichen Widerstandswert wie der Wellenwiderstand der Zuleitung aufweist, teilt sich der vom Lasertreiber erzeugte Modulationsstrom in zwei Hälften, von denen eine durch den Abschlußwiderstand fließt und damit für die Aussteuerung der Laserdiode nicht zur Verfügung steht; dies halbiert bei gegebener Treiberleistung die maximal mögliche Lichtleistung.

Die für Laserdiodensender für Bitraten im Giga-Bitbereich verwendeten Laserdioden weisen derzeit noch erhebliche Streuungen hinsichtlich des benötigten Modulationsstroms auf, der Modulationsstrombedarf kann bis zu etwa 100 mA betragen. Damit müßten vom Lasertreiber also Ströme von etwa 200 mA bei einigen GHz erzeugt werden. Dadurch steigen aber die Ansprüche an derartige Lasertreiber erheblich, so daß entweder auf Laserdioden mit höheren Modulationsströmen oder auf die Erzeugung höherer Lichtleistungen im Laserdiodensender verzichtet werden muß.

Die Aufgabe der Erfindung besteht also darin, einen Lasersender der eingangs erwähnten Art so weiter zu bilden, daß auch Laserdioden mit hohem Modulationsstrombedarf ausgesteuert werden können.

Erfindungsgemäß wird die Aufgabe bei einem Laserdiodensender der eingangs erwähnten Art dadurch gelöst, daß dieser durch die im Kennzeichen des Patentanspruchs 1 angeführten Merkmale weitergebildet ist.

Die erfindungsgemäße Lösung bietet den Vorteil des einfachen Aufbaus, der ohne Eingriffe in das Lasermodul und ohne Erhöhung der Verlustleistung des Lasertreibers auskommt.

Vorteilhafte Weiterbildungen des erfindungsgemäßen Laserdiodensenders sind in den Patentansprüchen 2 und 3 beschrieben.

Die Erfindung soll im folgenden anhand eines in der Zeichnung dargestellten Ausführungsbeispiels näher erläutert werden.

In der Zeichnung zeigt
- Fig. 1: ein Schaltbild eines erfindungsgemäßen Laserdiodensenders und
- Fig. 2: die Verläufe eines Normimpulses mit und ohne Anpassung mit Hilfe eines Leitungsnetzwerkes.

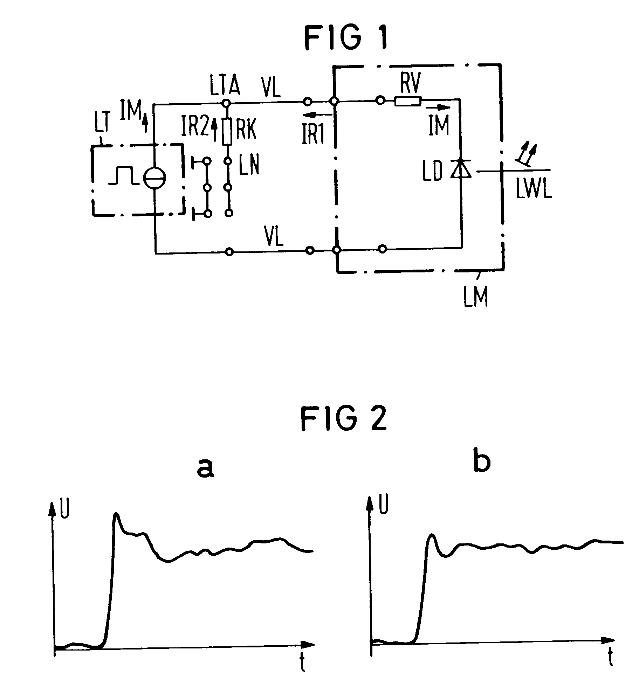

In der Fig. 1 ist der Lasertreiber LT über die Verbindungsleitung VL mit dem Lasermodul LM verbunden, daß die Laserdiode LD mit einem Vorwiderstand RV zur Impedanzanpassung enthält. Vom Lasertreiber LT wird der Modulationsstrom IM an die Laserdiode LD abgegeben, die entsprechende Lichtsignale an einen angeschlossenen Lichtwellenleiter LWL abgibt. An einen der beiden Ausgänge LTA des Lasertreibers LT ist über einen Ankoppelwiderstand RK ein Leitungsnetzwerk LN angeschlossen. Dieses Leitungsnetzwerk LN weist Stellen mit einem Wellenwiderstandssprung auf, der Abstand der Stelle vom Ausgangsanschluß LTA und damit auch vom Anfang der Verbindungsleitung VL ist so gewählt, daß die durch die Wellenwiderstandssprünge erzeugten Reflektionen IR2 mit den vom Lasermodul erzeugten Reflektionen IR1 am Ausgangsanschluß LTA zusammenfallen und sich wenigstens annähernd zu Null addieren. Durch das Leitungsnetzwerk LN werden also die Reflektionen des Lasermoduls LM nachgebildet und zu diesen Reflektionen invers addiert. Die Erfindung geht dabei von der Erkenntnis aus, daß zwar die Streuungen der Laserdiodenarbeitspunkte relativ groß sind und damit die Modulationsströme an jede Laserdiode individuell angepaßt werden müssen, die Streuungen hinsichtlich der Wellenwiderstände des Lasermoduls und der von ihm erzeugten Reflektionen aber typspezifisch sind, eine individuelle Anpassung also entfallen kann. Das Leitungsnetzwerk LN muß damit hinsichtlich seiner Bemessungen nur für den jeweiligen Typ der verwendeten Lasermodule bestimmt und angepaßt werden.

In der Fig. 2 sind Impulsanstiege am Ausgangsanschluß LTA eines Lasertreibers im Falle der Fig. 2a ohne Leitungsnetzwerk und im Falle Fig. 2b mit einem Leitungsnetzwerk dargestellt. Es ist erkennbar, daß der Eingangsstrom und damit auch die Eingangsimpedanz eines Lasermoduls trotz sorgfältiger Optimierung aufgrund der erzeugten Reflektionen ohne Leitungsnetzwerk immer noch erhebliche Schwankungen der Eingangsimpedanz aufweist und damit erhebliches Überschwingen nach dem Impulsanstieg auftritt. Der aus der Fig. 2b ersichtliche Kurvenverlauf zeigt, daß das Überschwingen erheblich reduziert ist. Der Ersatz des Abschlußwiderstandes zwischen den beiden Ausgangsanschlüssen des Lasertreibers LT durch das erfindungsgemäße Leitungsnetzwerk, das zur Dämpfung zwischen Ausgangsanschluß LTA des Lasertreibers und einzelnen Leitungsstücken einen Ankoppelwiderstand RK enthält, bewirkt also nicht nur eine Halbierung des zu erzeugenden Modulationsstroms sondern auch eine Verringerung des Überschwingens.

Für den praktischen Aufbau des erfindungsgemäßen Laserdiodensenders wird von einer keramischen Trägerplatte ausgegangen, die neben metallischen Kontaktflecken für die Anschlüsse des Lasermoduls bereits metallische Leiterbahnen aufweist. Eine dieser Leiterbahnen verändert an einigen Stellen ihre Breite, sodaß sich jeweils eine plötzliche Änderung des Wellenwiderstandes dieser Leiterbahn ergibt. Zusammen mit dem Ankopplungswiderstand stellt diese Leiterbahn das Leitungsnetzwerk LN dar. Die keramische Trägerplatte ist außerdem Träger der den Lasertreiber umfassenden integrierten Schaltung.

## Patentansprüche

1. Laserdiodensender mit einer Treiberstufe und einem elektrisch daran angepaßten, eine Laserdiode enthaltenden Lasermodul, bei dem die Anpassung durch ein an die Verbindungsleitung zwischen Lasertreiber (LT) und Lasermodul (LM) angeschlossenes Leitungsnetzwerk (LN) erfolgt,
**dadurch gekennzeichnet,**
daß das Leitungsnetzwerk (LN) wenigstens eine Stelle mit einem Wellenwiderstandssprung aufweist und
daß diese Stelle so gewählt ist, daß die von ihr erzeugte Reflektion des Ausgangssignals des Lasertreibers (LT) sich mit wenigstens einer vom Lasermodul (LM) erzeugten Reflektion invers zu annähernd Null addiert.

2. Laserdiodensender nach Patentanspruch 1,
**dadurch gekennzeichnet,**
daß wenigstens zwei der Hauptreflektionen des Lasermoduls (LM) hinsichtlich ihrer Laufzeit bis zum Ausgangsanschluß (LTA) des Lasertreibers (LT) bestimmt werden und das Leitungsnetzwerk (LN) wenigstens zwei Stellen mit Wellenwiderstandssprüngen aufweist, deren Abstand vom Ausgangsanschluß (LTA) so gewählt ist, daß die Laufzeit der erzeugten Reflektionen mit der Laufzeit der vom Lasermodul erzeugten Reflektionen wenigstens annähernd übereinstimmt.

3. Laserdiodensender nach Patentansprüchen 1 oder 2,
**dadurch gekennzeichnet,**
daß das Leitungsnetzwerk (LN) einen Ankoppelwiderstand (RK) enthält, über den Leitungsstücke an den Ausgangsanschluß (LTA) des Lasertreibers (LT) angeschlossen sind.

## Claims

1. Laser diode transmitter having a driver stage and a laser module, electrically matched thereto, containing a laser diode, in which the matching is performed by a network (LN) connected to the connecting line between laser driver (LT) and laser module (LM), characterised in that the network (LN) has at least one point having a step change in surge impedance, and in that said point is chosen such that the reflection it generates of the output signal of the laser driver (LT) adds together inversely with at least one reflection generated by the laser module (LM) to give approximately zero.

2. Laser diode transmitter according to Patent Claim 1, characterised in that at least two of the principle reflections of the laser module (LM) are determined with regard to the travel time up to the output terminal (LTA) of the laser driver (LT) and the network (LM) has at least two points having step changes in surge impedance, whose distance from the output terminal (LTA) is chosen such that the travel time of the reflections generated coincides at least approximately with the travel time of the reflections generated by the laser module.

3. Laser diode transmitter according to Patent Claims 1 or 2, characterised in that the network (LN) contains a coupling resistor (RK) via which pieces of line are connected to the output terminal (LTA) of the laser driver (LT).

## Revendications

1. Emetteur à diode laser comportant un étage d'attaque et un module laser adapté à cet étage d'attaque et comprenant une diode laser, dans lequel l'adaptation s'effectue par un réseau (LN) de ligne connecté à la ligne de liaison entre le circuit (LT) d'attaque laser et le module laser (LM),
caractérisé en ce que,
le réseau (LN) de ligne a au moins un point ayant un saut de résistance caractéristique et
ce point est choisi de telle sorte que la réflexion du signal de sortie du circuit (LT) d'attaque laser produite par lui s'additionne de manière inverse pour donner à peu près zéro avec au moins une réflexion produite par le module laser (LM).

2. Emetteur à diode laser suivant la revendication 1,
caractérisé en ce que
le temps de propagation d'au moins deux des réflexions principales du module laser (LM) jusqu'au raccordement (LTA) de sortie du circuit (LT) d'attaque laser sont déterminées et le réseau (LN) de ligne comporte au moins deux points à sauts de résistance caractéristique dont la distance au raccordement (LTA) de sortie est choisie de telle sorte que le temps de propagation des réflexions produites concorde au moins approximativement avec le temps de propagation des réflections produites par le module laser.

3. Emetteur à diode laser suivant les revendications 1 ou 2,
caractérisé en ce que
le réseau (LN) de lignes comprend une résistance (RK) de couplage, par laquelle des tronçons de ligne sont connectés au raccordement (LTA) de sortie du circuit (LT) d'attaque laser.
